# EUROPEAN PATENT SPECIFICATION

(11) **EP 4 304 197 B1**
(45) Date of publication and mention of the grant of the patent: **03.12.2025**
(21) Application number: 22182959.1
(22) Date of filing: 05.07.2022
(51) Int. Cl.: H04R 1/10, H04R 5/033, H04R 25/00

(54) **HEADSET WITH CAPACITIVE SENSOR**
KOPFHÖRER MIT KAPAZITIVEM SENSOR
CASQUE DOTÉ D'UN CAPTEUR CAPACITIF

(43) Date of publication of application: 10.01.2024
(73) Proprietor: GN Hearing A/S, 2750 Ballerup (DK)
(72) Inventor: STANKOVIC, Boris, 2750 Ballerup (DK)
(74) Representative: GN Store Nord A/S

(56) References cited:
- EP-A2- 3 151 584
- WO-A1-2016/070188
- WO-A1-2020/201341
- CN-U- 213 426 407
- US-A1- 2011 182 458
- US-A1- 2018 364 804
- US-B1- 11 272 288

## Description

### TECHNICAL FIELD

The present disclosure relates to a headset.

### BACKGROUND

Power consumption and methods for lowering power consumption in headsets continues to be a vital aspect when designing headsets. Presently, a plethora of solutions have been created for solving problems relating to power consumption, be it improving battery characteristics, lowering power consumption of headset components, or methods for on-head detection.

On-head detection helps in improving power consumption by controlling one or more configurations of the headset in response to determining whether the headset is on-head or off-head. For example, the headset may pause audio being played by the headset when the headset is determined to be off-head, and resume playing the audio when the headset is determined to be on-head, thus lowering the power consumption.

A variety of solutions for on-head detection for headsets have been developed and are well described within the prior art. These solutions may be of a capacitive, acoustic, or optic nature.

An example of an on-head detection solution is described in WO20201341 A1 which discloses a method of determining whether a hearing device is on-head or off-head, wherein the hearing device comprises at least a first capacitive proximity sensor. The sensor is adapted to detect a first capacitive load C, which varies depending on the proximity of the head or ear of a user. The sensor compensates for drift during use, whereby a reliable on-head detection is obtained.

Patent publication WO 2020/201341 A1 shows the features of the pre-amble of claim 1. Patent publication US 2018/364804 A1 shows a deformable fabric with electrically conductive elements in a two-dimensional matrix arrangement to implement a pressure sensor due to fabric deformation, which are primarily applied to a glove having pressure sensors, and which can further be applied to a headband structure of a headset for wearing status detection.

However, there is still room for improvement in on-head detection solutions.

### SUMMARY

It is an object of the present disclosure to provide an improved headset which overcomes or at least alleviates the problems of the prior art. These and other objects of the disclosure are achieved by the disclosure defined in the independent claims and explained in the following description. Further objects of the disclosure are achieved by embodiments defined in the dependent claims and in the detailed description of the disclosure.

According to a first aspect of the disclosure a headset is provided comprising the set of features of claim 1.

Consequently, an improved headset is provided. By having a flexible material forming the first sense electrode it allows for the sense electrode to maintain a constant distance to the head and/or the ear of a user wearing the headset, hence, allowing for uniform and stable capacitive data to be collected by the first sense electrode which allows for a more precise determination of whether the headset is on-head or off-head. Furthermore, the first sense electrode may adapt to different head shapes and/or ear shapes, thus allowing the sense electrode to adapt to different users of the headset, thus giving an adaptable solution.

The headset may be configured to be worn by a user. The headset may be arranged at the user's ear, on the user's ear, over the user's ear, in the user's ear, in the user's ear canal, behind the user's ear, and/or in the user's concha, i.e., the headset is configured to be worn at the user's ear.

The headset may be configured to be worn by a user at each ear, e.g., a headset with two earcups. The headset may be configured to be worn by a user at one ear, e.g., a headset with one earcup. In the embodiment where the headset is to be worn at both ears, the components meant to be worn at each ear may be connected, such as wirelessly connected and/or connected by wires, and/or by a strap. The components meant to be worn at each ear may be substantially identical or differ from each other.

The headset may be a headphone, a hearing protection device, a one-size-fits-all headset, a custom headset, or another head-wearable headset.

The headset may be embodied in various housing styles or form factors. Some of these form factors are on the ear headphones, or over the ear headphones. A person skilled in the art is aware of various kinds of headset and of different options for arranging the headset in and/or at the ear of the headset wearer.

The headset comprises a plurality of input transducers. The plurality of input transducers may comprise a plurality of microphones. The plurality of input transducers may be configured for converting an acoustic signal into an electric input signal. The electric input signal may be an analogue signal. The electric input signal may be a digital signal. The plurality of input transducers may be coupled to one or more analogue-to-digital converters configured for converting the analogue input signal into a digital input signal.

The headset may comprise one or more antennas configured for wireless communication. The one or more antennas may comprise an electric antenna. The electric antenna is configured for wireless communication at a first frequency. The first frequency may be above 800 MHz, preferably a wavelength between 900 MHz and 6 GHz. The first frequency may be 902 MHz to 928 MHz. The first frequency may be 2.4 to 2.5 GHz. The first frequency may be 5.725 GHz to 5.875 GHz. The one or more antennas may comprise a magnetic antenna. The magnetic antenna may comprise a magnetic core. The magnetic antenna comprises a coil. The coil may be coiled around the magnetic core. The magnetic antenna is configured for wireless communication at a second frequency. The second frequency may be below 100 MHZ. The second frequency may be between 9 MHZ and 15 MHZ.

The headset may comprise one or more wireless communication units. The one or more wireless communication units may comprise one or more wireless receivers, one or more wireless transmitters, one or more transmitter-receiver pairs, and/or one or more transceivers. At least one of the one or more wireless communication units may be coupled to the one or more antennas. The wireless communication unit may be configured for converting a wireless signal received by at least one of the one or more antennas into an electric input signal. The headset may be configured for wired/wireless audio communication, e.g., enabling the user to listen to media, such as music or radio, and/or enabling the user to perform phone calls.

A wireless signal may originate from external sources, such as spouse microphone devices, wireless audio transmitter, a smart computer, and/or a distributed microphone array associated with a wireless transmitter.

The headset may be configured for wireless communication with one or more external devices, such as one or more accessory devices, such as a smartphone and/or a smart watch.

The headset may comprise one or more processing units. The processing unit may be configured for processing one or more input signals. The processing may comprise compensating for a hearing loss of the user, i.e., apply frequency dependent gain to input signals in accordance with the user's frequency dependent hearing impairment. The processing may comprise performing feedback cancellation, beamforming, tinnitus reduction/masking, noise reduction, noise cancellation, speech recognition, bass adjustment, treble adjustment, face balancing and/or processing of user input. The processing unit may be a processor, an integrated circuit, an application, functional module, etc. The processing unit may be implemented in a signal-processing chip or a printed circuit board (PCB). The processing unit is configured to provide an electric output signal based on the processing of one or more input signals. The processing unit may be configured to provide one or more further electric output signals. The one or more further electric output signals may be based on the processing of one or more input signals. The processing unit may comprise a receiver, a transmitter and/or a transceiver for receiving and transmitting wireless signals. The processing unit may control one or more playback features of the headset.

The headset may comprise an output transducer. The output transducer may be coupled to the processing unit. The output transducer may be a loudspeaker, or any other device configured for converting an electrical signal into an acoustical signal. The receiver may be configured for converting an electric output signal into an acoustic output signal.

The wireless communication unit may be configured for converting an electric output signal into a wireless output signal. The wireless output signal may comprise synchronization data. The wireless communication unit may be configured for transmitting the wireless output signal via at least one of the one or more antennas.

The headset may comprise a digital-to-analogue converter configured to convert an electric output signal or a wireless output signal into an analogue signal.

The headset may comprise a power source. The power source may comprise a battery providing a first voltage. The battery may be a rechargeable battery. The battery may be a replaceable battery. The power source may comprise a power management unit. The power management unit may be configured to convert the first voltage into a second voltage. The power source may comprise a charging coil. The charging coil may be provided by the magnetic antenna.

The headset may comprise a memory, including volatile and non-volatile forms of memory.

The first earcup may be configured for being worn over the ear of a user of the headset. The first earcup may be configured for being worn on the ear of a user of the headset.

The support structure may comprise a polymer material, a metal material, or a combination of these. The support structure may be connected to a headband of the headset. The support structure may form a housing configured to house one or more electrical components and/or one or more transducers. The support structure may be configured for housing an integrated circuit.

The cushion may be formed purely by the first electrically conductive material or by one or more further materials. In one or more embodiments the cushion comprises a foam structure, where the first electrically conductive material is arranged on the foam structure. The first electrically conductive material may be connected to the cushion by an adhesive or mechanical connection. Alternatively, the first electrically conductive material may be provided as a foam structure, e.g., a metallic foam or an otherwise electrically conducting foam, such as a conductive polymer foam, for example, a conductive polyurethane foam.

The first electrically conductive material may be a material with a Young's modulus below 1 GPa, 0.75 GPa, 0,5 GPa, 0.25 GPa, or 0.1 GPa. The first electrically conductive material may be provided as a mesh, a wire, particles, or a plate. Preferably, the first electrically conductive material is provided with a shape which facilitates that the first electrically conductive material conforms to a head and/or an ear of a user wearing the headset.

The first sense electrode may be configured to capacitively couple to skin of a user of the headset when the user is wearing the headset. The first sense electrode may be configured to obtain capacitive data by measuring a change in mutual capacitance or self-capacitance. The first sense electrode may be configured to capacitively couple to skin of the user by being in near proximity to the skin of the user. The capacitive data generated by the first sense electrode may be transmitted to an analog to digital converter to convert the capacitive data into a digital electrical signal which may be further processed by a processing unit.

In an embodiment the cushion comprises a cover layer configured for contacting skin of a user of the headset when worn, and wherein the first electrically conductive material is integrally connected to the cover layer.

Consequently, the first electrically conductive material is kept in near proximity to the skin of a user wearing the headset, thus, improving the capacitive coupling between the skin and the first sense electrode, hence, allowing for obtaining improved data regarding whether the headset is on-head or off-head.

When writing the cover layer is configured to contact skin of the user it does not necessitate the contact layer being in contact with the skin of the user, e.g., if the user is wearing a hat or have long hair the cover layer may instead contact the hair or the hat.

The cover layer may comprise artificial leather, fabric, leather, natural fibers, polymer material, etc. The cover layer may be connected to the support structure of the headset. The cover layer may extend to cover other components of the cushion fully or partly. The cover layer may have a thickness of 0.5mm, 1mm, 2mm, 3mm, 4mm, or 5mm.

The first conductive material may be integrally connected to the cover layer throughout the cover layer, alternatively, the first conductive material may be integrally connected to parts of the cover layer. The first conductive material may be integrally connected to parts of the cover layer to form a plurality of sense electrodes each configured for capacitively-coupling to skin of a user of the headset, when the user is wearing the headset.

The first conductive material may be integrally connected with the cover layer by being coated on the cover layer. The first conductive material may comprise conductive particles deposited on the cover layer to form a conductive coating on the cover layer.

The first conductive material may be integrally connected with the cover layer by impregnation.

In an embodiment the cover layer comprises a conductive textile comprising the first electrically conductive.

A conductive textile may facilitate the integral connection between the cover layer and the first electrically conductive material, furthermore a conductive textile may ensure that the comfort of wearing the headset is not diminished.

A conductive textile may be achieved by interweaving the first electrically conductive material with the cover layer, in such an example the first electrically conductive material may be provided as metal strands or metal wires. A conductive textile may also be achieved by impregnation or other methods. The conductive textile may be achieved by providing the first electrically conductive material as conductive wires and interweaving the conductive wires with the cover layer.

The first electrically conductive material is preferably integrally connected to the cover layer to avoid the first electrically conductive material contacting skin of the user while the headset is worn. This may be achieved by integrally connecting the first electrically conductive material to a back-side of the cover layer, i.e., opposite of a user side of the cover layer configured to contact the skin of the user.

In an embodiment the cover layer defines a user side facing towards the user's head when the headset is worn, and wherein the first sense electrode covers an area of the user side of 100 mm², 200 mm², 400 mm², or 600 mm².

By providing a large area for the first sense electrode it allows for capacitive data to be collected over a larger area. By collecting the capacitive data over a larger area, it may reduce the risk of false positives caused by the user grabbing the headset or otherwise interacting with the headset without wearing it in the intended wear position. Capacitive data collected over a larger area allows for improved processing of the capacitive data to filter away false positives. Having the first sense electrode covering an area of above 100 mm² allows for data to be collected over a big enough area to sort away false positives occurring by one finger capacitively coupling to the first sense electrode. Furthermore, situations where the user has long hair or is wearing a hat covering their ears collecting data over a larger area may improve the sensitivity enough to determine whether the headset is on-head or off-head.

Furthermore, the first electrically conductive material being flexible allows for the first electrically conductive material to cover a larger area, without having to worry about compromising the comfort of wearing the headset.

When writing the first sense electrode covers an area of above 100 mm², 200 mm², 400 mm², or 600 mm² it may be understood as the first sense electrode being configured to detect user interaction with the headset over an area of the user side of 100 mm², 200 mm², 400 mm², or 600 mm². When writing the first sense electrode covers an area of at least 100 mm², 200 mm², 400 mm², or 600 mm² it may be interpreted as the first sense electrode having an area of at least 200 mm², 400 mm², or 600 mm².

In an embodiment the cushion comprises a cover layer configured for contacting skin of the user of the headset when the user is wearing the headset, wherein the cover layer defines a user side facing towards the user's head when the headset is worn, and wherein the first electrically conductive material is arranged opposite the user side.

In an embodiment the cushion comprises a cushion support and a cover layer configured for contacting skin of the user of the headset when the user is wearing the headset, and wherein the first electrically conductive material is arranged in-between the cover layer and the cushion support.

Consequently, the cover layer may shield the first electrically conductive material thereby protecting the first electrically conductive material from impacts and contaminants. Furthermore, as the first electrically conductive material is placed in-between the cover layer and the cushion support, the distance to the skin of a user wearing the headset is kept short, thus assuring that a good capacitive coupling can be achieved.

The cushion support may be a foam structure or similar. The cushion support may be connected to the support structure of the headset. The cushion support may be fully or at least partly covered by the cover layer.

The first electrically conductive material may directly abut the cover layer and the cushion support, thus forming a sandwich structure. The first electrically conductive material may be provided as a conductive polymer layer arranged in-between the cover layer and the cushion support.

In an embodiment the cover layer defines a user side facing towards the user's head when the headset is worn, and wherein the first electrically conductive material extends in parallel to the user side to cover an area of at least 100 mm², 200 mm², 400 mm², or 600 mm².

In an embodiment the headset further comprises,
a second earcup comprising, a support structure, and a cushion, wherein the cushion comprises a second electrically conductive material forming a second sense electrode, wherein the second sense electrode is configured for obtaining second capacitive data indicative of whether the second earcup is on-head or off-head, the second electrically conductive material is a flexible material configured to deform dependent on the head shape and/or the ear shape of the user of the headset when the user is wearing the headset.

Having both earcups provided with sense electrodes may further improve the reliability of the on-head off-head detection and reduce the number of false positives.

The second ear cup may be identical to the first earcup, alternatively, the second earcup may differ from the first earcup.

In an embodiment the first sense electrode forms part of a mutual capacitance sensor, and wherein the first electrically conductive material further forms a second sense electrode forming part of the mutual capacitance sensor.

A mutual capacitance sensor relies on measuring a change in the capacitance between a transmitter electrode and the receiver electrode, which may be formed by the second sense transmitter electrode and the second sense receiver electrode. The change in capacitance may occur by the skin of a user capacitively coupling to transmitter electrode, hence resulting in a change in the capacitance between the transmitter electrode and the receiver electrode.

In an embodiment the first electrically conductive material forms a plurality of transmitter electrodes and a plurality of receiver electrodes, and wherein the plurality of transmitter electrodes and the plurality of receiver electrodes form part of a mutual capacitance sensor.

In an embodiment the first sense electrode is part of a self-capacitance sensor.

A self-capacitance sensor relies on measuring a change in the capacitance with respect to ground. The change in capacitance with respect to ground may occur by the skin of a user capacitively coupling to the first sense electrode.

In an embodiment the first electrically conductive material is arranged to be within 0 mm - 20 mm, 0 mm - 10 mm, or 0 mm - 5 mm from the skin of the user when the headset is worn by the user.

Keeping the first electrically conductive material close to the skin of the user allows for the first sense electrode to capacitively couple to the skin to allow data regarding on-head and off-head detection to be obtained.

In an embodiment the headset further comprises a processing unit, and wherein the processing unit is electrically connected to the first electrically conductive material by a conductive glue.

Conductive glue provides a strong and non-destructive connection with a large connection surface. In an embodiment the conductive glue is directly glued to the first electrically conductive material and the processing unit. The processing unit may be provided as an integrated circuit. The processing unit may comprise a PCB with an integrated circuit arranged on the PCB, wherein the conductive glue is directly glued to the PCB and the first electrically conductive material. In contrast, many traditional capacitive solutions rely on a mechanical clip for achieving a connection between the sense electrode and the processing unit, in such solutions the mechanical clip delivers a point force to the conductive material to connect it to a PCB, however, the conductive material is prone to be ripped at the location of the point force, thus risking ruining the electrical connection.

In an embodiment the headset further comprises a processing unit, wherein the processing unit comprises a first capacitive electrode, and wherein the first capacitive electrode is capacitively coupled to the first electrically conductive material.

A capacitive coupling allows for a connection where data can be transmitted without relying on the components being in contact with each other, thus, problems with the connection deteriorating over time due to ripping of the materials are obviated.

The first capacitive electrode may be arranged on or otherwise electrically connected to a PCB.

In an embodiment the processing unit is configured to:
receive the first capacitive data, and
determine whether the headset is on-head or off-head based on the received first capacitive data.

The processing unit may be configured to compare the first capacitive data to a threshold to determine whether the headset is on-head or off-head. The processing unit may be configured to determine a change in capacitance from the capacitive data, and based on the change in capacitance determine whether the headset is on-head or off-head,

In an embodiment the processing unit is further configured to:
control functionality of the headset based on whether the headset is determined to be on-head or off-head.

The processing unit may be configured to pause playback or turn-off the device. The processing unit may be configured to switch the headset from a high-power mode, e.g., playback of audio, to a low-power mode, e.g., a pause mode where playback is paused, or the headset is turned off.

Within this document, the singular forms "a", "an", and "the" specify the presence of a respective entity, such as a feature, an operation, an element, or a component, but do not preclude the presence or addition of entities. Likewise, the words "have", "include" and "comprise" specify the presence of respective entities, but do not preclude the presence or addition of entities. The term "and/or" specifies the presence of one or more of the associated entities.

### BRIEF DESCRIPTION OF THE DRAWINGS

The disclosure will be explained in more detail below together with preferred embodiments and with reference to the drawings in which:
Fig. 1 shows a schematic drawing of a headset according to an embodiment of the present disclosure.
Figs 2a to 2c show different schematic cross-sections of earcups according to different embodiments of the present disclosure.
Figs 3a and 3b show different schematic views of connections between the first electrically conductive material and a processing unit.

The figures are schematic and simplified for clarity, and they just show details essential to understanding the disclosure, while other details may be left out. Where practical, like reference numerals and/or labels are used for identical or corresponding parts.

### DETAILED DESCRIPTION OF THE DRAWINGS

The detailed description given herein and the specific examples indicating preferred embodiments of the disclosure are intended to enable a person skilled in the art to practice the disclosure and should thus be regarded mainly as an illustration of the disclosure. The person skilled in the art will be able to readily contemplate applications of the present disclosure as well as advantageous changes and modifications from this description without deviating from the scope of the disclosure. Any such changes or modifications mentioned herein are meant to be non-limiting for the scope of the disclosure. An aspect or an advantage described in conjunction with a particular embodiment is not necessarily limited to that embodiment and can be practiced in any other embodiments even if not so illustrated, or if not so explicitly described.

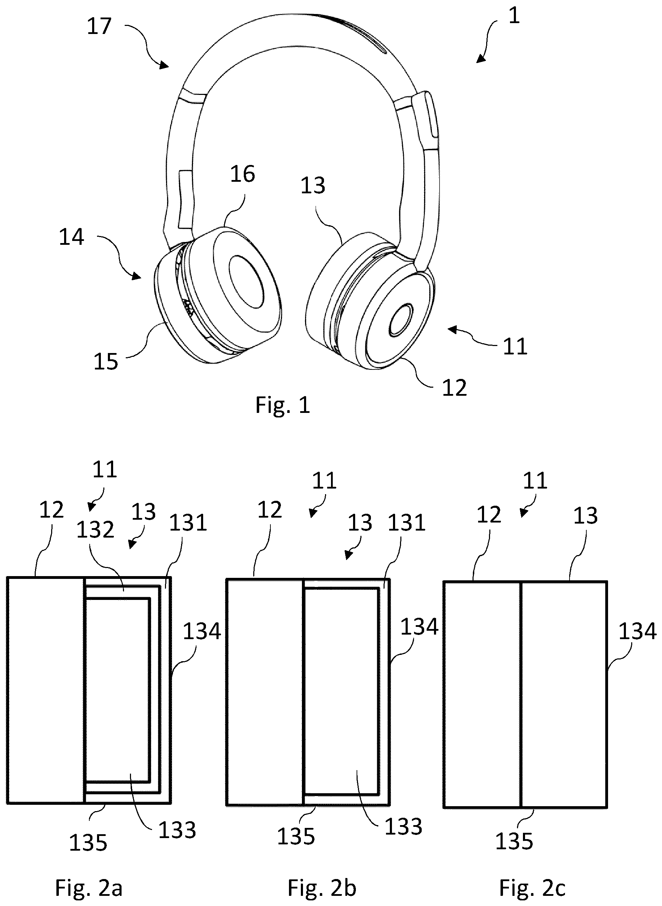

Referring initially to Fig. 1 showing a schematic drawing of a headset 1 according to an embodiment of the present disclosure. Headset 1 comprises a first earcup 11 comprising, a support structure 12, and a cushion 13. In the shown embodiment the headset further comprises a second earcup 14 comprising, a support structure 15, and a cushion 16. Although a headset 1 with two earcups 11, 14 is shown, the present disclosure is not limited to headsets with two earcups, in other embodiments the headset 1 may only comprise the first ear cup 11. The two ear cups 11, 14 are connected via a headband 13. The first ear cup 11 may be substantially identical to the second ear cup 14, alternatively, the first ear cup 11 may differ from the second ear cup 14. In the present embodiment the first ear cup 11 is substantially identical to the second ear cup 14. Consequently, even though the following description relates to the first cup 11 it may be equally applicable to the second ear cup 14.

The cushion 13 comprises a first electrically conductive material which forms a first sense electrode. The first sense electrode is configured for capacitively-coupling to skin of a user of the headset when worn. The first sense electrode is configured for obtaining first capacitive data indicative of whether the first earcup 11 is on-head or off-head. The first electrically conductive material is a flexible material configured to deform dependent on a head shape and/or an ear shape of a user of the headset when the user is wearing the headset 1. The first electrically conductive material may capacitively couple to the skin of a user by being in near proximity to the skin of the user.

Referring to Fig. 2a which shows a schematic cross-section of an earcup 11 according to an embodiment of the present disclosure. The earcup 11 comprises a cushion 13 and a support structure 12. The support structure 12 may be configured for housing one or more electrical components, such as integrated circuits, PCBs (Printed Circuit Board), transducers. The cushion 13 is connected to the support structure 12. The cushion 13 comprises a cushion support 133. The cushion support 133 may be a foam which is adhered to or mechanically connected to the support structure 12. The cushion 12 further comprises a cover layer 131. The cover layer 131 is configured for contacting the skin of the user of the headset when the user is wearing the headset. The cover layer 131 in the shown embodiment extends to fully cover the cushion support 133. The cover layer 131 may act as a protection layer protecting layers and materials covered by the cover layer 131, furthermore the cover layer 131 may act to enhance the comfort of wearing the headset 1. Arranged in-between the cover layer 131 and the cushion support 133 is a first electrically conductive material 132. The first electrically conductive material 132 may be arranged as a layer sandwiched in-between the cover layer 131 and the cushion support 133. The first electrically conductive material 132 may arranged as a conductive thread connected to the cushion support 133 and/or the cover layer 131. The first electrically conductive material 132 forms a first sense electrode. The first sense electrode is configured for capacitively-coupling to skin of a user of the headset when worn. The first sense electrode is configured for obtaining first capacitive data indicative of whether the first earcup 11 is on-head or off-head. The first electrically conductive material 132 is a flexible material configured to deform dependent on a head shape and/or an ear shape of a user of the headset when the user is wearing the headset. The cover layer 131 extends to define a user side 134 facing towards the user's head when the earcup 11 is worn by a user. The first electrically conductive material 132 is arranged as a layer extending in parallel with the user side 134 defined by the cover layer 131. The first electrically conductive material 132 extends in parallel to the user side 134 to cover an area of at least 200 mm², 400 mm², or 600 mm². In the shown embodiment, the cover layer 131 further extends away from the user side to define a side wall 135. The first electrically conductive material 132 extends in parallel with the side wall 135 defined by the cover layer 131. In other embodiments, the first electrically conductive material 132 only extends in parallel with the user side 134. The first electrically conductive material may be a conductive textile, or a conductive polymer layer. The first electrically conductive material 132 is arranged to be within 0 mm - 10 mm, 0 mm - 5 mm, or 0 mm - 2 mm from the skin of the user when the headset is worn by the user.

Referring to Fig. 2b which shows a schematic cross-section of an earcup 11 according to an embodiment of the present disclosure. The earcup 11 comprises a cushion 13 and a support structure 12. Cushion 13 comprises a cushion support 133. The cushion support 133 may be foam which is adhered to or otherwise connected to the support structure 12. The cushion 12 further comprises a cover layer 131. Cover layer 131 is configured for contacting skin of the user of the headset when the user is wearing the headset. 2. The earcup 11 further comprises a first electrically conductive material. The first electrically conductive material is integrally connected to the cover layer 131. The cover layer 131 may comprise a conductive textile, where the conductive textile comprises the first electrically conductive material, e.g., in the form of interwoven metallic strands. The cover layer 131 may be fully made from a conductive textile, or parts of the cover layer 131 may be made from a conductive textile. The cover layer defines a user side 134 facing towards the user's head when the headset is worn. The first electrically conductive material covers an area of the user side of 200 mm², 400 mm², or 600 mm².

Referring to Fig. 2c which shows a schematic cross-section of an earcup 11 according to an embodiment of the present disclosure. The earcup 11 comprises a cushion 13 and a support structure 12. The first electrically conductive material fully defines the cushion in the shown embodiment, e.g., the first electrically conductive material may be a conductive foam, such as a conductive polyurethane foam.

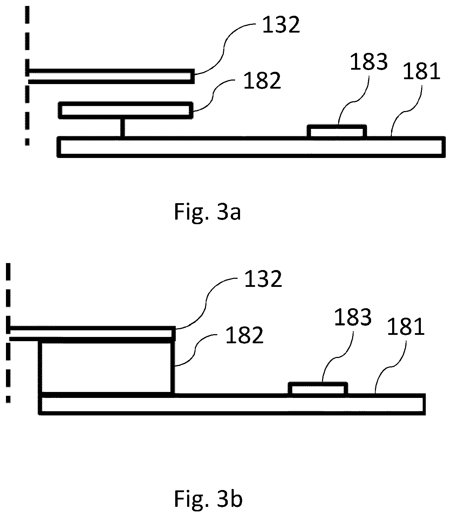

Referring to Fig. 3a showing a schematic view of a connection between the first electrically conductive material 132 and a processing unit 183. The processing unit 183 is provided as an integrated circuit 183 on a PCB 181. Furthermore, a capacitive electrode 182 is electrically connected to the PCB 181. The capacitive electrode 182 is capacitively coupled to the first electrically conductive material 132.

Referring to Fig. 3b which shows a schematic view of a different connection between the first electrically conductive material 132 and a processing unit 183. The processing unit 183 is provided as an integrated circuit 183 on a PCB 181. The first electrically conductive material 132 is electrically connected to the PCB 182 by an electrically conductive glue 182.

In both embodiments shown in figs 3a and 3b, the processing unit 183 is configured to receive first capacitive data collected by the first electrically conductive material 132. The processing unit 183 is further configured to determine whether the headset is on-head or off-head based on the received first capacitive data. The processing unit 183 may control the functionality of the headset based on whether the headset is determined to be on-head or off-head.

The disclosure is not limited to the embodiments disclosed herein, and the disclosure may be embodied in other ways within the subject-matter defined in the following claims. As an example, features of the described embodiments may be combined arbitrarily, e.g., to adapt devices according to the disclosure to specific requirements.

Any reference numerals and labels in the claims are intended to be non-limiting for the scope of the claims.

## Claims

1. A headset (1) comprising:
a first earcup (11) comprising a support structure (12) and a cushsion (13), wherein a first sense electrode is configured for obtaining first capacitive data indicative of whether the first earcup is on-head or off-head, **characterized in that** the cushion comprises a first electrically conductive material (132) forming the first sense electrode, wherein the first electrically conductive material (132) is a flexible material configured to deform dependent on a head shape and/or an ear shape of a user of the headset when the user is wearing the headset.

2. A headset according to claim 1, wherein the cushion comprises a cushion support ; (133) and a cover layer (131) configured for contacting skin of the user of the headset when the user is wearing the headset, and wherein the first electrically conductive material is arranged in-between the cover layer and the support structure.

3. A headset according to claim 2, wherein the cover layer defines a user side (134) facing towards the user's head when the headset is worn, and wherein the first electrically conductive material extends in parallel to the user side to cover an area of at least 100 mm², 200 mm², 400 mm², or 600 mm².

4. A headset according to claim 1, wherein the cushion comprises a cover layer configured for contacting skin of a user of the headset when worn, and wherein the first electrically conductive material is integrally connected to the cover layer.

5. A headset according to claim 4, wherein the cover layer comprises a conductive textile comprising the first electrically conductive material.

6. A headset according to claim 4 or 5, wherein the cover layer defines a user side facing towards the user's head when the headset is worn, and wherein the first electrically conductive material covers an area of the user side of 100 mm², 200 mm², 400 mm², or 600 mm².

7. A headset according to any of the preceding claims, further comprising,
a second earcup (14) comprising a second support structure (15), and a second cushion (16), wherein the second cushion (16) comprises a second electrically conductive material which forms a second sense electrode, wherein the second sense electrode is configured for obtaining second capacitive data indicative of whether the second earcup is on-head or off-head, the second electrically conductive material is a flexible material configured to deform dependent on the head shape and/or the ear shape of the user of the headset when the user is wearing the headset.

8. A headset according to any of the preceding claims, wherein the first sense electrode forms part of a mutual capacitance sensor, and wherein the first electrically conductive material further forms a second sense electrode forming part of the mutual capacitance sensor.

9. A headset according to any of the preceding claims, wherein the first sense electrode is part of a self-capacitance sensor.

10. A headset according to any of the preceding claims, wherein the first electrically conductive material is arranged to be within 0 mm - 20 mm, 0 mm - 10 mm, or 0 mm - 5 mm from the skin of the user when the headset is worn by the user.

11. A headset according to any of the preceding claims further comprising a processing unit (183), and wherein the processing unit is electrically connected to the first electrically conductive material by a conductive glue.

12. A headset according to any of claims 1-10, further comprising a processing unit, wherein the processing unit comprises a first capacitive electrode (182), and wherein the first capacitive electrode is capacitively coupled to the first electrically conductive material.

13. A headset according to any of claims 11 or 12, wherein the processing unit is configured to:
receive the first capacitive data, and
determine whether the headset is on-head or off-head based on the received first capacitive data.

14. A headset according to claim 13, wherein the processing unit is further configured to: control functionality of the headset based on whether the headset is determined to be on-head or off-head.

## Patentansprüche

1. Headset (1), umfassend:
eine erste Hörmuschel (11), umfassend eine Stützstruktur (12) und ein Kissen (13), wobei eine erste Sensorelektrode dazu ausgebildet ist, erste kapazitive Daten zu erhalten, die anzeigen, ob die erste Hörmuschel auf dem Kopf oder nicht auf dem Kopf ist, **dadurch gekennzeichnet, dass** das Kissen ein erstes elektrisch leitfähiges Material (132) umfasst, das die erste Sensorelektrode bildet, wobei das erste elektrisch leitfähige Material (132) ein flexibles Material ist, das dazu ausgebildet ist, sich in Abhängigkeit von einer Kopfform und/oder einer Ohrform eines Benutzers des Headsets zu verformen, wenn der Benutzer das Headset trägt.

2. Headset nach Anspruch 1, wobei das Kissen eine Kissenstütze (133) und eine Deckschicht (131) umfasst, die dazu ausgebildet ist, die Haut des Benutzers des Headsets zu berühren, wenn der Benutzer das Headset trägt, und wobei das erste elektrisch leitfähige Material zwischen der Deckschicht und der Stützstruktur angeordnet ist.

3. Headset nach Anspruch 2, wobei die Deckschicht eine dem Kopf des Benutzers zugewandte Benutzerseite (134) definiert, wenn das Headset getragen wird, und wobei sich das erste elektrisch leitfähige Material parallel zur Benutzerseite erstreckt, um einen Bereich von mindestens 100 mm2, 200 mm2, 400 mm2 oder 600 mm2 abzudecken.

4. Headset nach Anspruch 1, wobei das Kissen eine Deckschicht umfasst, die für das Berühren der Haut eines Benutzers des Headsets beim Tragen ausgebildet ist, und wobei das erste elektrisch leitfähige Material integral mit der Deckschicht verbunden ist.

5. Headset nach Anspruch 4, wobei die Deckschicht ein leitfähiges Textil umfasst, das das erste elektrisch leitfähige Material umfasst.

6. Headset nach Anspruch 4 oder 5, wobei die Deckschicht eine dem Kopf des Benutzers zugewandte Benutzerseite definiert, wenn das Headset getragen wird, und wobei das erste elektrisch leitfähige Material einen Bereich der Benutzerseite von 100 mm2, 200 mm2, 400 mm2 oder 600 mm2 abdeckt.

7. Headset nach einem der vorhergehenden Ansprüche, ferner umfassend
eine zweite Hörmuschel (14), die eine zweite Kissenstütze (15) umfasst, und ein zweites Kissen (16), wobei das zweite Kissen (16) ein zweites elektrisch leitfähiges Material umfasst, das eine zweite Sensorelektrode bildet, wobei die zweite Sensorelektrode zum Empfangen zweiter kapazitiver Daten ausgebildet ist, die anzeigen, ob die zweite Hörmuschel auf dem Kopf oder nicht auf dem Kopf ist, das zweite elektrisch leitfähige Material ein flexibles Material ist, das dazu ausgebildet ist, sich in Abhängigkeit von der Kopfform und/oder der Ohrform des Benutzers des Headsets zu verformen, wenn der Benutzer das Headset trägt.

8. Headset nach einem der vorhergehenden Ansprüche, wobei die erste Sensorelektrode Teil eines Sensors mit gegenseitiger Kapazität ist, und wobei das erste elektrisch leitfähige Material ferner eine zweite Sensorelektrode bildet, die Teil des Sensors mit gegenseitiger Kapazität ist.

9. Headset nach einem der vorhergehenden Ansprüche, wobei die erste Sensorelektrode Teil eines Selbstkapazitätssensors ist.

10. Headset nach einem der vorhergehenden Ansprüche, wobei das erste elektrisch leitfähige Material dazu angeordnet ist, innerhalb von 0 mm - 20 mm, 0 mm - 10 mm oder 0 mm - 5 mm von der Haut des Benutzers entfernt zu sein, wenn das Headset vom Benutzer getragen wird.

11. Headset nach einem der vorhergehenden Ansprüche, das ferner eine Verarbeitungseinheit (183) umfasst, und wobei die Verarbeitungseinheit elektrisch mit dem ersten elektrisch leitfähigen Material durch einen leitfähigen Klebstoff verbunden ist.

12. Headset nach einem der Ansprüche 1 bis 10, ferner umfassend eine Verarbeitungseinheit, wobei die Verarbeitungseinheit eine erste kapazitive Elektrode (182) umfasst und wobei die erste kapazitive Elektrode kapazitiv mit dem ersten elektrisch leitfähigen Material kapazitiv gekoppelt ist.

13. Headset nach einem der Ansprüche 11 oder 12, wobei die Verarbeitungseinheit dazu ausgebildet ist:
die ersten kapazitiven Daten zu empfangen und
auf der Grundlage der empfangenen ersten kapazitiven Daten zu bestimmen, ob das Headset auf dem Kopf oder nicht auf dem Kopf ist.

14. Headset nach Anspruch 13, wobei die Verarbeitungseinheit weiter dazu ausgebildet ist:
die Funktionalität des Headsets zu steuern, basierend darauf, ob das Headset als auf-dem-Kopf oder nicht-auf-dem-Kopf bestimmt wird.

## Revendications

1. Casque d'écoute (1) comprenant :
un premier écouteur (11) comprenant une structure de support (12) et un coussin (13), dans lequel une première électrode de détection est configurée pour obtenir les premières données capacitives indiquant si le premier écouteur est sur la tête ou hors de la tête, **caractérisé en ce que** le coussin comprend un premier matériau électriquement conducteur (132) formant la première électrode de détection, dans lequel le premier matériau électriquement conducteur (132) est un matériau flexible configuré pour se déformer en fonction de la forme de la tête et/ou de l'oreille d'un utilisateur du casque lorsque l'utilisateur porte le casque.

2. Casque d'écoute selon la revendication 1, dans lequel le coussin comprend un support de coussin (133) et une couche de couverture (131) configuré pour entrer en contact avec la peau de l'utilisateur du casque d'écoute lorsque l'utilisateur porte le casque d'écoute, et dans lequel le premier matériau électriquement conducteur est disposé entre la couche de couverture et la structure de support.

3. Casque d'écoute selon la revendication 2, dans lequel la couche de couverture définit un côté de l'utilisateur (134) orienté vers la tête de l'utilisateur lorsque le casque d'écoute est porté, et dans lequel le premier matériau électriquement conducteur s'étend parallèlement au côté de l'utilisateur pour couvrir une zone d'au moins 100 mm2, 200 mm2, 400 mm2 ou 600 mm2.

4. Casque d'écoute selon la revendication 1, dans lequel le coussin comprend une couche de couverture configurée pour entrer en contact avec la peau d'un utilisateur du casque d'écoute lorsqu'il est porté, et dans lequel le premier matériau électriquement conducteur est intégralement connecté à la couche de couverture.

5. Casque d'écoute selon la revendication 4, dans lequel la couche de couverture comprend un textile conducteur comprenant le premier matériau électriquement conducteur.

6. Casque d'écoute selon la revendication 4 ou 5, dans lequel la couche de couverture définit un côté de l'utilisateur orienté vers la tête de l'utilisateur lorsque le casque d'écoute est porté, et dans lequel le premier matériau électriquement conducteur couvre une zone du côté de l'utilisateur de 100 mm2, 200 mm2, 400 mm2 ou 600 mm2.

7. Casque d'écoute selon l'une quelconque des revendications précédentes, comprenant en outre,
un deuxième écouteur (14) comprenant, une deuxième structure de support (15) et un deuxième coussin (16), dans lequel le deuxième coussin (16) comprend un deuxième matériau électriquement conducteur qui forme une deuxième électrode de détection, dans lequel la deuxième électrode de détection est configurée pour obtenir des deuxièmes données capacitives indiquant si le deuxième écouteur est sur la tête ou hors de la tête, le deuxième matériau électriquement conducteur est un matériau flexible configuré pour se déformer en fonction de la forme de la tête et/ou de l'oreille de l'utilisateur du casque d'écoute lorsque l'utilisateur porte le casque d'écoute.

8. Casque d'écoute selon l'une quelconque des revendications précédentes, dans lequel la première électrode de détection fait partie d'un capteur de capacité mutuelle, et dans lequel le premier matériau électriquement conducteur forme en outre une deuxième électrode de détection faisant partie du capteur de capacité mutuelle.

9. Casque d'écoute selon l'une quelconque des revendications précédentes, dans lequel la première électrode de détection fait partie d'un capteur d'autocapacité.

10. Casque d'écoute selon l'une quelconque des revendications précédentes, dans lequel le premier matériau électriquement conducteur est agencé de manière à se trouver à moins de 0 mm à 20 mm, de 0 mm à 10 mm ou de 0 mm à 5 mm de la peau de l'utilisateur lorsque le casque d'écoute est porté par l'utilisateur.

11. Casque d'écoute selon l'une quelconque des revendications précédentes, comprenant en outre une unité de traitement (183), et dans lequel l'unité de traitement est reliée électriquement au premier matériau électriquement conducteur par une colle conductrice.

12. Casque d'écoute selon l'une quelconque des revendications 1 à 10, comprenant en outre une unité de traitement, dans lequel l'unité de traitement comprend une première électrode capacitive (182), et dans lequel la première électrode capacitive est couplée capacitivement au premier matériau électriquement conducteur.

13. Casque d'écoute selon l'une quelconque des revendications 11 ou 12, dans lequel l'unité de traitement est configurée pour :
recevoir les premières données capacitives et
déterminer si le casque d'écoute est sur la tête ou hors tête sur la base des premières données capacitives reçues.

14. Casque d'écoute selon la revendication 13, dans lequel l'unité de traitement est en outre configurée pour :
contrôler la fonctionnalité du casque d'écoute selon que le casque d'écoute est déterminé comme étant sur la tête ou hors tête.
